# EUROPEAN PATENT SPECIFICATION

(11) **EP 2 988 579 B1**
(45) Date of publication and mention of the grant of the patent: **12.06.2019**
(21) Application number: 14181872.4
(22) Date of filing: 22.08.2014
(51) Int. Cl.: H05K 7/20

(54) **Oil cooling configuration for an electronic subsea system**
Ölkühlungskonfiguration für ein elektronisches Unterwassersystem
Configuration de refroidissement d'huile pour un système sous-marin électronique

(43) Date of publication of application: 24.02.2016
(73) Proprietor: ABB Schweiz AG, 5400 Baden (CH)
(72) Inventor: Gradinger, Thomas, 5032 Aarau Rohr (CH); Laneryd, Tor, SE-722 18 Västerås (SE)
(74) Representative: Savela, Reino Aleksi

(56) References cited:
- EP-A1- 2 487 327
- EP-A1- 2 501 212
- WO-A1-2014/071985

## Description

### TECHNICAL FIELD

The present invention relates to an electronic subsea system comprising a cooling system.

### BACKGROUND

Electric and electronic subsea installations and devices usually demand high standards regarding durability, long-term functionality and independence during operation. Electric installations that need to be cooled during operation, such as subsea converters, require an autonomous and durable cooling of its components. It is known to use a dielectric liquid such as for example an oil as cooling fluid. In such subsea applications, the ambient hydrostatic pressure increases by 1 bar for each 10 m of water depth. Two basic technological concepts forsee either the installation of a thick-walled container comprising the electric subsea installations and devices, keeping the interior pressure at 1 bar in order to protect sensitive electronics of the electric subsea installations and devices. A second concept foresees the installation of a thin-walled container comprising the electric subsea installations and devices and being filled with an insulating, incompressible liquid which automatically takes on the ambient hydrostatic pressure, thus requiring adaption of sensitive parts inside the container.

In general electric subsea installations need to be pressurized with the dielectric fluid, thus said fluid, which is preferably a liquid, should be, at least almost, incompressible. The dielectric liquid is used as a cooling medium and as an electric insulation medium for components placed in the electric installation from a housing, and insulation from other electric equipment in the same housing such as electric conductors or busbars and other components.

Referring specifically to subsea converters there are some requirements that make the construction of a subsea converters quite challenging. Due to the high reliability that is usually required, and since it is not easy to modify and provide access for maintenance for the subsea converter or for the electric installation from the outside, normally specialized personnel and specialized equipment is hired, which is expensive and complicated and which can lead to a long downtime of the electric converter.

Cooling systems for electric equipment and specifically for electric subsea converters, are used to cool down electronic components, such as semiconductor modules, connections and electrical components such as capacitors. These components generate heat that needs to be dissipated by the cooling system. The cooling system of subsea converters are usually designed in a simple manner avoiding any unnecessary parts and mechanisms. Generally it is desirable to have passive cooling systems, thus cooling systems without any driven or powered parts, such as for example without pumps, to cool down the electric components.

In some cases natural convection is used. Natural convection helps to avoid the use of a pump but it has a low efficiency. Cooling by natural convection uses the heat exchange between the cooling liquid and the surrounding sea water to generate a circulation within the cooling system and thus within the electric installation and the subsea converter, respectively. Usually some kind of a heat exchanger is used to exchange heat between the cooling liquid and the sea water surrounding the housing. For example, EP2487327 entitled: Subsea electronic system, and assigned to Siemens AG, discloses a watertight enclosure 11 adapted to enable operation of the system under water. A heat generating electronic component 12 is arranged in the enclosure. The electronic component generates heat in operation. The enclosure is at least partially filled with a dielectric liquid 13 in which the electronic component is at least partially submerged. A heat sink is arranged on a wall of the enclosure and thermally coupled thereto. The transfer of heat by the heat sink from the dielectric liquid to the sea water surrounding the enclosure may thus be improved.

Conventional subsea converters are further comparably large, requiring a huge amount of dielectric liquid, such as oil, for the cooling system. Further, environmental regulations, laws or considerations may require that the smallest possible amount of oil is used.

Hence there is a need to improve the efficiency of the cooling system and the arrangement of modules in electric subsea converters.

### SUMMARY

One object of the present invention is to provide an improved electronic subsea system with an efficient cooling system and an optimized arrangement of modules.

In view of the above it is a particular object of the present invention to provide an electronic subsea system with improved cooling and which is thus is compact, powerful and versatile. Another particular object is the provision of a subsea converter system with an improved cooling system. Another object is the provision of a subsea converter system with an improved cooling system containing a reduced quantity of dielectric fluid.

Disclosed herein is an electronic subsea system that comprises a housing configured to receive a dielectric fluid.

According to a first aspect of the invention there is provided an electronic subsea system as defined in claim 1.

A second heat exchanger of the cooling system may be arranged in thermal connection with the semiconductor module.

The electronic subsea system, which may comprise an electric converter system, further comprises a second fluid stream path configured to receive a second fluid stream passing through the second section and through a third heat exchanger, the second fluid stream having a flow rate that differs from that of the first fluid stream. The second fluid stream may reach a lower operating temperature than the operating temperature of the first fluid stream. Thus it is advantageous to place temperature sensitive components in the second fluid stream. As the temperature sensitive components do not generate a great amount of heat in operation when compared to semiconductor devices for example, a driving component is installed at or near the top of the stack in the second fluid stream. The term driving component is used in this description to denote an apparatus with greater thermal losses than most of the temperature sensitive equipment, even if they are not so high when compared, for example, to thermals losses of IGBTs. A suitable driving component may for example be a reactor, a heater, a filter circuit.

The third heat exchanger connected to receive the second fluid stream may be configured with a centre of gravity that is higher than the centre of gravity of the dielectric fluid in the housing. The third heat exchanger connected to receive the second fluid stream may also be configured with a centre of gravity that is higher than an electric or electronic component placed at or near the top of a vertical arrangement of components or stack.

An electronic subsea system with the features indicated above has the advantage that different fluid streams can be used to cool down different components, which means that the fluid streams can be adapted to different or specific cooling requirements. The first fluid stream may for example have a higher flow rate than the second fluid stream, thus, in this example, the capacity of the first stream to cool down electronic or electric components arranged in the first section of the electric module may be higher than the capacity of the second fluid stream.

It is clear that third, fourth, fifth, etc. fluid stream paths and streams, respectively may be installed and used in the cooling system. The invention is not limited to a specific number of fluid stream paths and fluid streams respectively.

The fluid stream paths and the cooling system, respectively, are configured to be adapted to different heat dissipation requirements of various electric components and thus the flow rates of the correspondent fluid streams may differ from one another. Depending on the geometry of the fluid stream paths different reductions in fluid density, and thus greater or lesser convection flows of dielectric fluid, may be achieved.

The cooling system may be driven by natural convection. This avoids the use of a pump or other driven mechanism to circulate the fluid. In this way the effect of a possible pump failure on the cooling system is avoided.

Advantageously the first section of the at least one stackable electronic or electric module may comprise a semiconductor element and an inter module bus portion. The second section may comprise a capacitor element.

The semiconductor module normally has a higher heat flux than the capacitor and thus the first heat exchanger is used to dissipate the heat away from the semiconductor element. The first fluid stream of the first fluid stream path is used to cool down a second heat exchanger element. Thus in the specific case the flow rate per cross section or the flow speed of the first stream is higher than the flow rate per cross section or the flow speed of the second stream flowing in the second stream path, since the capacitor element has a lower heat flux than the semiconductor element.

The semiconductor element may be an insulated gate bipolar transistor (IGBT), but not necessarily.

Modular multilevel converters (MMC) may be particularly suitable for subsea use, since they are reliable. MMCs are configured to provide redundant power modules or power cells. More power modules are included than the number needed for normal operation, so that in case of a failure of one or more modules one or more of the redundant modules are used. It is possible to arrange the power modules in rows and columns (stacks). The cooling system may be adapted to the arrangement of MMC power modules. It is possible to adapt the cooling system to the modularity of the power cells, meaning that the cooling system as a whole is modular. Thus the modules or stackable electric modules have a multilevel topology and the electric converter system may be a multilevel converter system.

In case MMCs are used, the cell capacitors and the IGBTs need to be cooled, thus the first fluid stream may be used to cool the IGBTs and the second fluid stream may be used to cool the cell capacitors.

In general the IGBTs or semiconductor elements have a high heat dissipation and thus a high heat flux but on the other hand they can operate at temperatures of up to 125°C. The capacitors have a lower power dissipation and a lower heat flux and their maximum operating temperature has to be kept rather low in order to have a long lifetime. The cooling system is configured to fulfil both of these requirements.

A modularity of the power modules and the cooling system may provide a high flexibility and versatility of the converter system and it enables an easy mounting of the power modules in the housing of the converter system. The invention, however, is not limited to cell-based converter technologies or MMCs; any other suitable power converter topology such as a switch-based topology may be used within the scope of the present invention.

The compact and modular arrangement with an improved cooling for the dielectric fluid means that the volume of oil needed in the converter housing is reduced when compared with the amount of fluid used by state of the art subsea electronic systems. The reduced amount of oil is an advantage for complying with a requirement to reduce the amount of oil present from regulatory or environmental considerations. In addition, transportation of a converter system out to a subsea location is a critical limitation for subsea converter systems. Firstly, there available space is limited on the ships such as support ships used to transport subsea equipment from land out to sea. Secondly, when installing equipment subsea at great depths, remotely operated vehicles (ROVs) have to be used to manoeuvre, assemble and also connect items of equipment to be installed on or near the seabed. The use of ROVs to handle the equipment means that equipment such as converter systems should be as light and compact as possible. Reducing the amount of oil needed in a converter housing reduces the weight and size of the tank; it also reduces the number or size of pressure compensators required to adapt for thermal expansion of the oil during operation, which has a further impact on the converter tank or housing dimensions.

In an advantageous embodiment the cooling system comprises a third fluid stream path configured to receive a third fluid stream, said third fluid stream being configured to cool down the inter module bus bar portion.

It is possible to provide an electronic converter with an arbitrary number of fluid stream paths and thus fluid streams. Using a lot of fluid stream paths may however influence the size of the electric converter.

The dielectric fluid used may be oil and the electric converter may be configured for subsea use, thus preferably pressurized and sealed.

As already indicated while discussing the MMCs the electric converter may comprise a plurality of stackable electric power modules forming vertical stacks. The first section and the second section are arranged in series in respect to the first and second fluid stream and thus with the first and second fluid stream paths.

The semiconductor elements of one vertical stack may be arranged in series with the first fluid stream and the capacitor elements may be arranged in series with the second fluid stream. The first and second fluid streams and fluid stream paths may thus be oriented vertically in a region close to the stackable power modules. It is possible to use a number of vertical stacks. According to one embodiment in the range of 3 to 18 stacks are used.

Advantageously the first heat exchanger may be configured to exchange heat between the dielectric fluid and the sea water surrounding the housing in order to cool down the dielectric fluid. The first heat exchanger may have various configurations and one of the many possible examples is given below.

At least one wall portion of the housing may be configured to form part of the first heat exchanger. At least one wall portion may comprise first heat exchanger fins protruding from an outer side of the wall portion and from an inner side of the wall portion into at least one of the first, second and third fluid stream path. Fins arranged in thermal contact with the first heat exchanger protruding from the outer side of the wall portion, into the sea water, are configured to transfer heat to the sea water.

The cooling system used in an electronic subsea system comprising electrical power equipment such as an electronic converter according to an embodiment is designed, among other things, to avoid the heating of certain electric components by other electronic components, which means that components arranged in the first space do not heat components arranged in the second space and additionally also neighbouring electric components do not heat each other.

According to a second aspect of the invention a method is provided for operating an electronic subsea system as described herein.

This method may advantageously used at any time when the temperature of dielectric fluid in the second section is determined to be low by any combination of direct measurement, indirect measurement, estimation, modelling, simulation. Natural convention flow and temperature of dielectric fluid in the second section may be low at any time such as for example just before, or during, a start-up phase. Similarly it may be advantageous to provide electric power to the driving component during a time just before, or during, a period when capacitor losses are estimated or measured to be lower than a predetermined value.

Generally, all terms used in the claims are to be interpreted according to their ordinary meaning in the technical field, unless explicitly defined otherwise herein. All references to "a/an/the element, apparatus, component, means, step, etc." are to be interpreted openly as referring to at least one instance of the element, apparatus, component, means, step, etc., unless explicitly stated otherwise. The steps of any method disclosed herein do not have to be performed in the exact order disclosed, unless explicitly stated.

### BRIEF DESCRIPTION OF THE DRAWINGS

The invention is now described, by way of example, with reference to the accompanying drawings, in which:
Fig. 1 shows a side view of a cross section of an electric converter system according to the invention;
Fig. 2a shows a side view of a cross section of another electric converter system and Fig. 2b shows a top down view onto the other electric converter system according to Figure 2a;
Fig. 3 shows a graph of temperatures at different points in the electric converter system in relation to size of a heat exchanger for an embodiment of the electric converter system according to Figure 1;
Fig. 4 shows a schematic diagram of an electric converter system according to figure 1, showing in particular the electric converter system comprising an arrangement of Modular Multilevel Converters.

### DETAILED DESCRIPTION

The invention will now be described more fully hereinafter with reference to the accompanying drawings, in which certain embodiments of the invention are shown. This invention may, however, be embodied in many different forms and should not be construed as limited to the embodiments set forth herein; rather, these embodiments are provided by way of example so that this disclosure will be thorough and complete, and will fully convey the scope of the invention to those skilled in the art. Like numbers refer to like elements throughout the description.

In this description the example of a converter installed subsea, such as a variable frequency converter, a voltage frequency converter, or variable speed drive comprising one of more electronic modules, is used to explain the invention. However, the invention may also be applied to other devices that may comprise electronic modules, such as power devices in the form of a rectifier, inverter or other electrical or electronic constructions that include more than one such electronic device. The invention is thus not limited to converters and is only to be limited by the scope of the claims.

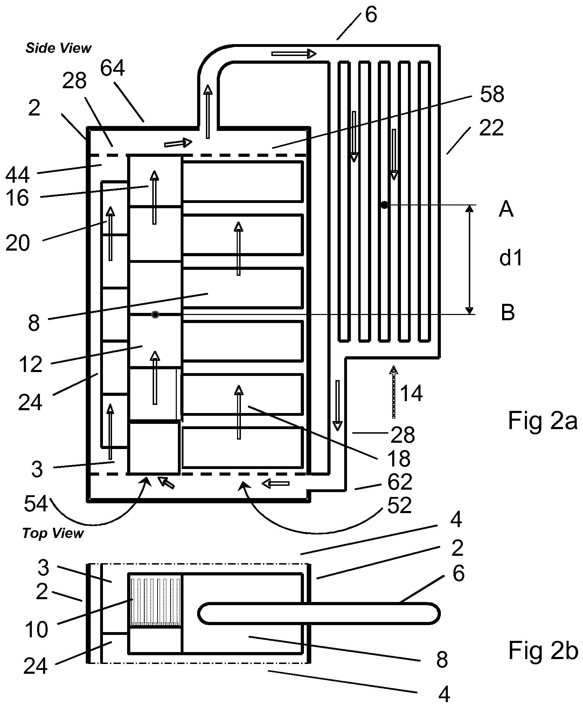

Figures 2a, 2b show a pre-existing subsea converter system which was disclosed in an EP patent application number EP 13175768.4 entitled Oil-Cooling Configuration for Subsea Converter, assigned to ABB Technology Ltd and filed on 09/07/2013. Figure 2a shows a view from one side and Figure 2b shows a view looking down from above the subsea system comprising an electric converter comprising a housing 2, stackable electric modules 4 and a cooling system 6. The stackable electric modules 4 are arranged in the housing 2. The stackable electric modules 4 may be Modular Multilevel Converters (MMCs), but the electric or electronic modules 4 may not be limited to MMCs; other modules such as for example two-level converters, three-level converters or MMC variants may be used. The housing 2 is filled with a dielectric liquid 3 or dielectric oil surrounding the electric and electronic components in the housing.

The stackable electric modules 4 are arranged in vertical stacks 58 forming a power module also known as power electronic building block (PEBB). The electric converter 1 is thus made up of plurality of vertical stacks 58. The number of vertical stacks 58 used can vary, which means that the electric converter can be configured and equipped a size and number of stacks 58 depending on application needs such as for example requirements of the power grid. From the figures it is clear that the electric converter system is modular.

As may be seen in the side view diagram Figure 2a the stackable electric module 4 comprises a first section 54 and a second section 52 whereby the first and second section 54, 52 each comprise various and different electric components. The first section 54 comprises an inter module bus bar portion 24, which is connected to a supply via terminals (not shown), and a semiconductor element 12 such as an insulated gate bipolar transistors (IGBT). The invention is however not limited to the use of IGBTs as semiconductor element, IGCTs may be used, and other semiconductor elements, such as a metal oxide semiconductor field effect transistor (MOSFET) fall within the scope of the invention. The second section 52 comprises a capacitor element 8. The capacitor element 8 can take up a lot of space, in some cases up to 80% of the volume of the stackable electric module 4.

The cooling system 6 comprises a fluid loop configuration, a first heat exchanger 22 and a second heat exchanger 10 arranged with cooling fins, and shown in the top view Figure 2b, and associated with the electronic part of the modules 4 and also with a substantially horizontal baffle element 44' arranged with a mesh or holes or other apertures of some sort. The fluid loop configuration comprises a first fluid stream path configured to receive and guide a first fluid stream 16, a second fluid stream path configured to receive and guide a second fluid stream 18 and a third fluid stream path configured to receive and guide a third fluid stream 20. The paths of the first, second and third fluid streams 16, 18, 20 are configured to pass the first and second sections of a vertical stack 58 of stackable electric modules 4 in substantially parallel streams.

The fluid loop configuration is thus configured to have a, at least more or less, vertical branch that corresponds at least approximately to a height of the corresponding vertical stack 58. The fluid loop passes along and through the first and second section 54, 52 of the stackable electric modules 4 as illustrated in Figure 2a. The vertical upwards branch of the fluid loop configuration comprises the paths of the first, second and third fluid streams 16, 18, 20 which pass through or along the first and second sections 54, 52 in a vertical direction as indicated with vertically inclined arrows in the figure. The electric converter shown in the figure is used for subsea applications. The first heat exchanger 22 is thus used to exchange heat energy between a dielectric fluid 3 and the sea water. Figure 2a shows a stack 58 of 6 modules arranged in the tank or housing 2. Oil flows upwards in fluid stream comprising a plurality of fluid streams 16, 18, 20 through the modules and leaves the tank or housing at its top 64. The oil is then guided to the first heat exchanger 22, an oil-to-sea-water heat exchanger. In the figure, the centre of gravity A of this heat exchanger 22 configured such that it is raised with respect to the centre of gravity (B) of the stack 58 to enhance natural convection.

The circulation of the fluid is driven by natural convection, which will now be illustrated referring to the figures, in particular to Figures 2a, 2b. The fluid of the first, second, and third stream flows from the first heat exchanger 22, where it is cooled by heat exchange with sea water, via a fluid duct arrangement 28 to a bottom part 62 of the electric converter and the housing 2, respectively. From the bottom of the housing 2 the fluid flows in the first, second and third fluid stream paths in an at least more or less vertical direction upwards passing through and along the vertical stack 58 of stackable electric modules 4.

During this vertical upwards flow the fluid is heated by heat absorption from the electronic and electrical components of the stackable electric modules 4, such as the IGBT or semiconductor element 12, the capacitor element 8 and the inter-module bus bar portion 24. A second heat exchanger 10, Fig 2b, preferably arranged with cooling fins, is arranged in thermal connection with the semiconductor module 12. The semiconductor module 12 generates a high heat flux, which means a high amount of heat energy needs to be dissipated and the use of the second heat exchanger 10 improves the efficiency of the heat exchange between the dielectric fluid 3 and the semiconductor element 12. The electric components of the stackable electric module 4 and the first and second heat exchanger 22, 10, drive the fluid circulation in the fluid loop configuration and the paths of the first, second, and third fluid stream 16, 18, 20 respectively, by natural convection. An advantage of this separation of oil streams is as follows:
- The IGBT or other semiconductor modules 12 generate most of the heat in the module and have by far the highest heat loss density. Therefore, they need a high flow rate of oil. On the other hand, the IGBT modules can tolerate quite high temperatures (up to 125 °C). Therefore, the top IGBT module does not overheat even though the oil has been pre-heated by the IGBT semiconductor modules below it ("thermal stacking").
- In contrast, the capacitors 8 produce less heat and have a much lower heat loss density. Therefore, a much lower oil-flow rate (or speed) is sufficient for their cooling. However, the capacitors need to be exposed to a much lower local oil temperature than the IGBTs in order to work reliably and over sufficient lifetime. Typically, such a temperature is around 50 °C. Thus it is extremely advantageous to have a fluid stream to accommodate the high heat loss density which is a different fluid stream from a fluid stream to cool the low heat loss density.

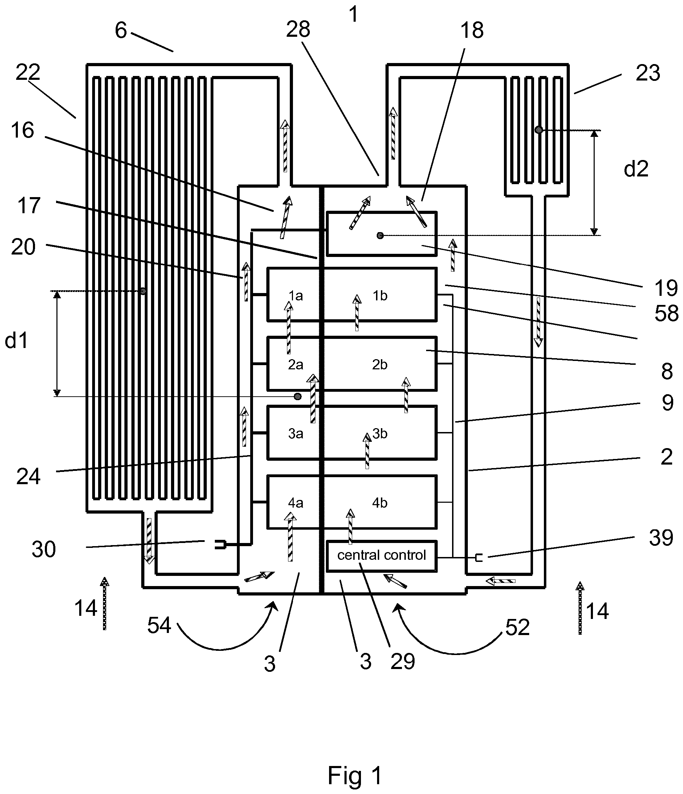

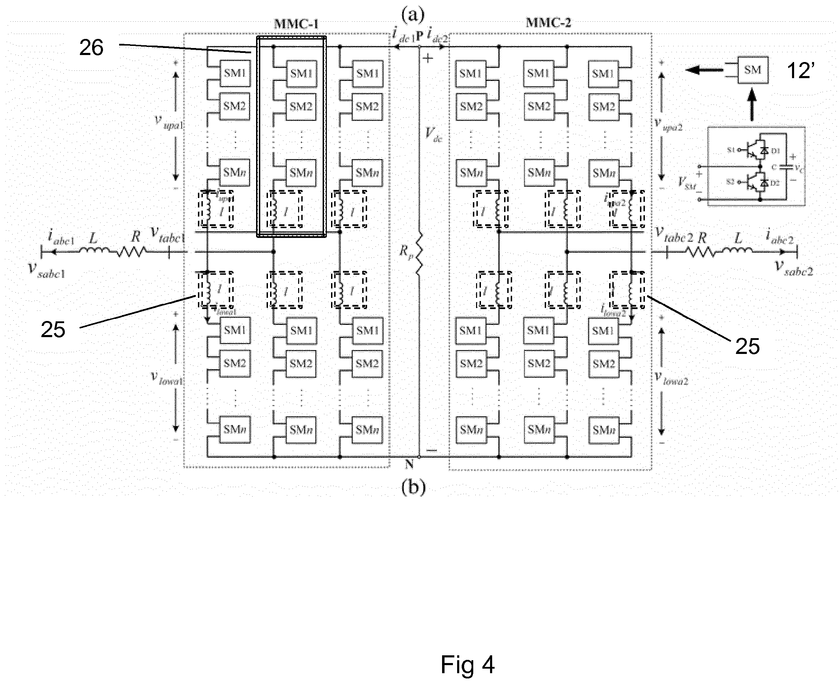

Reference is now made to Figures 1 and 4, which show various embodiments of the present invention. Figure 1 shows a subsea system comprising electrical and electronic components. The subsea system 1 in Figure 1 comprises a housing 2, stackable electronic modules 1a-4a and a second cooling system 6. The stackable electronic modules 1a-4a are arranged inside the housing 2 and are surrounded by a dielectric fluid 3. The stackable electronic modules 1a-4a may be IGBTs, but the electronic modules 1a-4a may not be limited to IGBTs or other modules such as for example IGCTs. Topologies such as two-level converters, three-level converters, MMCs or MMC variants may arranged in the housing 2 surrounded by a dielectric fluid 3.

The stackable electronic modules 1a-4a of Figure 1 are preferably arranged in vertical stacks forming a power module which may be of the type also known as power electronic building block (PEBB), similar to that described in relation to Figures 2a, 2b. The electronic modules 1a-4a comprise an IBGT or other semiconductor 12. The semiconductor 12 may be arranged with a second heat exchanger in the form of fins or a finned heat sink 10 similar to the heat exchanger 10 of the device of Figures 2a, 2b. Thus an electric converter may be constructed using a plurality of vertical stacks 58 such as suggested by 1a-4a in Figure 1. The number of such vertical stacks used can vary, which means that the electric converter can be equipped or specified depending on application, for example requirements of a subsea power grid. From Figures 1 and 4 it may be seen that the electric converter system may be arranged to be modular, that is, in a series of modules.

The stackable electric module 4 of Figure 1 comprises a first section 54 and a second section 52 whereby the first and second section comprise various electric components. The first section comprises an inter module bus bar portion 24, which is connected to a supply via a terminal 30, and a stack of semiconductor elements 1a-4a such as insulated gate bipolar transistors (IGBT). The invention is however not limited to the use of IGBTs as semiconductor element, IGCTs may be used or other semiconductor elements, such as a metal oxide semiconductor field effect transistor (MOSFET) fall within the scope of the invention. The second section comprises a vertical stack of modules 1b-4b containing electrical components such as capacitors. A capacitor element or a capacitor 8 can take up a lot of space, in some cases up to 80% of the volume of the stacked electric components or modules 1b-4b.

The electric converter shown in Figure 1 is used for subsea applications. The second heat exchanger 22 is thus used to exchange heat energy between the fluid 3 and the sea water 14 surrounding the housing 2.

In a preferred embodiment of the invention at least one of the first or third heat exchangers is configured so that the centre of gravity of the at least one heat exchanger is higher than the centre of gravity of the main body of the dielectric fluid 3 in the housing 2. This configuration makes use of the natural siphon effect of a fluid as well as a natural convection effect from the heated-up dielectric fluid to provide an improved flow. Thus the dielectric fluid that is warmed by the electronic and electric components in the housing 2 becomes more buoyant that the colder fluid in the housing and as a result moves upwards toward the heat exchanger. The fluid inside the heat exchanger is cooled by the surrounding sea water, becomes less buoyant, and sinks down through the heat exchanger toward the bottom part of the housing 2. In other words, the electronic subsea system comprises at least one heat exchanger 22, 23 which is configured to have a centre of gravity d1, d2 which is higher than the centre of gravity of the body of dielectric fluid 3 in the housing 2.

If a cooling cycle is designed and optimized for the IGBT modules only, the bottom oil temperature (= outlet temperature of the oil-to-sea-water first heat exchanger 22, = inlet temperature of the stack of modules) will be quite high. Depending on the case considered, values up to 80 °C result from numerical simulations.

The present invention solves a number of technical problems. If the cooling system is extended by a second oil stream 18 as shown in Figure 1, then the bottom temperature is too high for the cooling of capacitors, electronics and communication components. To lower the bottom temperature, the oil-to-sea-water heat exchanger needs to be significantly enlarged. Since this heat exchanger is large even if designed optimally for the IGBTs only, such a solution is not economical at all.

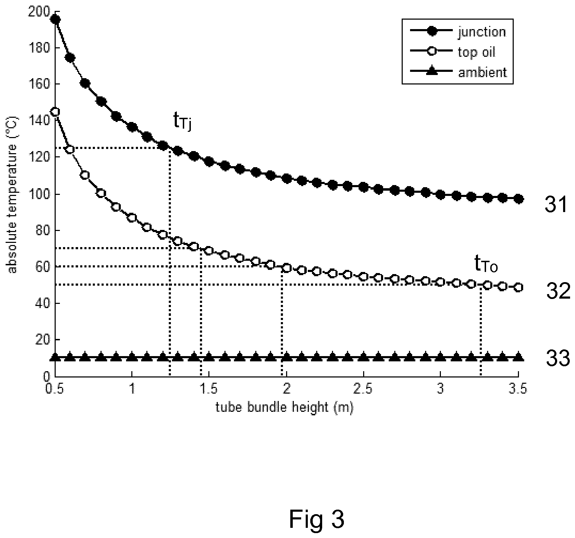

An example showing a relation between heat exchange size and various temperatures in or around a heat exchanger is shown in Figure 3, in which the top oil temperature, i.e. the oil temperature at the exit of the stack of modules, is plotted in a first curve 31. The dependence on the height or length of the tubes of a tube-bundle used as oil-to-sea-water heat exchanger is shown. The tube-bundle length is proportional to the volume, mass and cost of the heat exchanger. It can be seen that a tube length of 1.25 m is sufficient to limit the IGBT junction temperatures to an admissible value of 125°C at point tTj. Top oil temperature is plotted as curve 32. However, in order to lower the top oil temperature to 50°C, a tremendous increase of the tube length to 3.25 m is needed, at point tTo, which is not economical from an IGBT-cooling point of view.

According to an embodiment a cooling cycle may be provided for the temperature-sensitive components that is completely independent from that for the IGBTs. This cooling cycle is called "second cooling cycle" in the following. The second cooling cycle is provided by means of an own oil-to-sea-water third heat exchanger 23, such that the bottom oil temperature in second section 52 is independent from that of the first cooling cycle, which cools the IGBTs in first section 54.

The problem with this solution is that very little heat may be generated in the second cooling cycle. The losses of the temperature sensitive components such as electronics (gate drives, control unit 29) and communication bus 9 are generally low. The losses of the capacitors 8 are typically higher than those of the above mentioned electronics, but, for MMC converters, may vary strongly depending on operating state and application. Also, depending on the application, the capacitors losses may be quite low for MMC converters [2].

This means that, depending on the operating state, the overall heat input into the second cooling cycle may be so low that little or no natural convection results. In the absence of a natural convection flow, however, local overheating of components would occur, which would result in reduced operating lifetime.

Generally, the problem of the second cooling cycle may be stated as follows:
- If the losses are low, the natural convection is weak and the cooling poor;
- If the losses are higher, natural convection gets stronger, which, in principle, improves the cooling. However, increased losses also increase the effect of thermal stacking, i.e. the heating of the oil as it passes upwards from bottom to top module in the stack.

This makes it generally difficult to achieve low oil temperatures in the second cooling cycle.

According to a first aspect of the present invention, the above-described problem of cooling the temperature-sensitive components is solved by putting the temperature-sensitive components in series in a fluid stream with a non-temperature-sensitive component that produces losses high enough to create a "reliable" amount of natural convection. This latter component is called "driving component" in the following.

The driving component 19 is arranged stacked at the top of the stack of the temperature-sensitive components; i.e. in terms of flow path, the driving component 19 is located in a second fluid stream path and in-between the temperature-sensitive components (communication control unit 29, communication bus 9, capacitors 8) and the inlet 28 of the oil-to-sea-water third heat exchanger 23 at the top of second section 52. With this configuration the temperature-sensitive components are exposed to oil that has a temperature close to the bottom temperature, i.e. the outlet temperature of the oil-to-sea-water third heat exchanger 23 of the second cooling cycle. The oil only becomes heated significantly after passing the temperature-sensitive components, before rising to the inlet of the oil-to-sea-water heat exchanger. An example of such an arrangement is shown in Figure 3. The centre of gravity of the driving component 19 is lower than the centre of gravity of the oil-to-sea-water third heat exchanger 23 to promote natural convection.

Even though the losses of the driving component 19 are larger than those of the temperature-sensitive components, they are small compared to those of the IGBTs. Therefore, the oil-to-sea-water third heat exchanger 23 can be much smaller than the oil-to-sea-water first heat exchanger 22, as indicated schematically in Figure 1. It is therefore possible - if needed - to further reduce the bottom oil temperature of the second cooling cycle by increasing the relative size of the oil-to-sea-water third heat exchanger 23 without making its absolute size, weight and cost very large. The working lifetime of the capacitors in particular increases strongly as the temperature is reduced.

According to a second aspect of the invention a method is provided for operating an electronic subsea system wherein a driving component is supplied with electric power at a time when a temperature of dielectric fluid in the second section is estimated, simulated or modelled or else measured directly as a temperature measurement or indirectly as a function of a current and/or voltage load to be lower than a predetermined value.

This method may advantageously used at any time when the temperature of dielectric fluid in the second section is determined to be low by any combination of direct measurement, indirect measurement, estimation, modelling, simulation. Natural convention flow and temperature of dielectric fluid in the second section may be low at any time such as for example just before, or during, a start-up phase. Similarly it may be advantageous to provide electric power to the driving component during a time just before, or during, or otherwise in relation to a period when capacitor losses are estimated or measured to be lower than a predetermined value.

Referring again to Figure 1, the cooling system 6 comprises a first fluid loop configuration, with a first heat exchanger 22, a third heat exchanger 23 and at least one baffle element 17. The path of the first fluid stream 16 is configured to pass the vertical stack of stackable electronic modules 1a-4a in series. The first fluid stream 16 is also separated the baffle 17 from the second fluid stream 18. Thus the high heat loss density flow 18 past the electronic modules 1a-4a is for the most part physically separated from the low heat loss density stream 16 past the electric modules 1b-4b comprising components such as capacitor elements or capacitors 8. The second section 52 may comprise a communication bus 9 and a communication control unit 29.

In Figure 1 it may be seen that the centre of gravity of the first heat exchanger 22 is raised by a distance d1 with respect to the centre of gravity of the stack 58 to enhance natural convection. The centre of gravity of the second heat exchanger 22 is thus higher than the centre of gravity of the stack 58 of modules 1a-4a by an amount shown as d1 in the diagram. The fluid loop configuration comprises a first fluid stream path configured to receive and guide a first fluid stream 16 past electronic modules 1a-4a; and a second fluid stream path configured to receive and guide a second fluid stream 18 past electrical or electronic apparatus modules 1b-4b. The second fluid stream 18 is also configured to pass the vertical stack of stackable electrical or electronic modules 1b-4b in series. The second section 52 comprises at least one electric or electronic component 19, which is a component that generates heat, that is arranged at the top of the stack 58, or else above the stack 58 and in between the top of the stack and an inlet to the third heat exchanger 23.

The second fluid stream passes into the third heat exchanger 23 configured at a higher point relative to the housing 2. The centre of gravity d2 of the third heat exchanger 23 is higher than the centre of gravity d1 of the second heat exchanger 22. Third heat exchanger 23 is also configured such that its centre of gravity is higher than the centre of gravity of the topmost component 19 in or above the stack 58 of electrical or electronic modules 1b-4b as can be seen from by the distance shown schematically in Figure 1 as d2.

The fluid that is used for cooling of the stackable electric modules 1a-4a can be oil, mineral oil, an oil containing silicon or silicone, and/any other suitable dielectric fluid such as, for example, liquid esters.

According to another embodiment a solution is provided to the question of which apparatus or function to use as a driving component. It is conceivable to use the semiconductor module (with its attached finned heat sink 10) of the top module 1a in a stack as a driving component. Referring to Figure 1, this would mean that module space 1a needs to be shifted to the location of the driving component. While this is possible, there is a clear disadvantage. Module 1a would need to be built completely differently than all the other modules. For example, the intra-module bus bar 24 connecting power semiconductor and capacitors, would look totally different than in the other modules. In contrast, for simplicity of design, and for economy of manufacturing and assembly, one likes to have identical modules only. Another disadvantage of this solution is that the oil-flow rate of the second cooling cycle, fluid stream 18, may be too low to cool the power semiconductor of 1a efficiently, which has a much higher loss density than the temperature-sensitive components, as discussed above.

As a solution to this problem, according to the present embodiment, a component outside the modules is used as driving component 19. In an MMC, this can be a phase reactor, marked with reference number 25 and indicated surrounded by a dashed rectangle in Figure 4. The phase reactor occurs once per branch only, as shown in the figure. One such branch is marked with a plain rectangle 26 in Figure 4.

Ideally, according to the present invention, the modules of one branch 26 are stacked in one stack, with the corresponding phase reactor 25 on top acting as the driving component 19. Other devices that may be configured as a driving component are: a reactor, an input filter circuit, an output filter circuit, or a heater. An electrically powered heater, such as a resistance heater, may be considered for use as a driving component, and in particular for use on a temporary basis such as when oil temperatures are low during a start-up phase, or similar.

Since the phase reactor 25 is a purely inductive component which does not contain a capacitor, or electronics or fibre-optic communication lines, it can easily be designed to resist much higher temperatures than the temperature-sensitive components. It can therefore be put in the oil stream that is pre-heated by the temperature-sensitive components arranged below it. Hence, the phase reactor 25 is ideally suited for use as driving component 19.

According to a recent loss estimate for an 18 MVA converter, the total reactor losses amount to 18 kW and are in particular small compared to the IGBT losses. On the other hand, the reactor losses are larger than the losses of the temperature-sensitive components. Therefore - also in terms of loss magnitude - the reactors are suited for the function of driving components according to the discussion above.

According to another embodiment of the present invention, the central control unit, 29 in Figure 1, which contains electronics and is also temperature sensitive, is also arranged in section 52 and thus in the cold oil stream of the second cooling cycle, see Figure 1. It can be seen in the figure that also the communication bus 9, which connects the central control unit 29 with the modules, as well as the connection to the control terminal 39, is entirely located in the cold oil stream. A communication terminal 39, connected to the communication bus 9 is arranged for communication between the converter system 1 and other systems in a subsea network.

Further details noteworthy in Figure 1 are the following:
- The oil-to-sea-water third heat exchanger 23 is much smaller than the first heat exchanger 22, due to the much lower losses in the second cooling cycle;
- The centre of gravity of both oil-to-sea-water heat exchangers 22, 23 is vertically offset compared with the centre of gravity of the heat input of the cooling cycle, to promote natural convection.
- Next to the semiconductors 12, also the inter module power bus 24 and the connection to the power terminal 30 is located in the first section 54 thus in the first cooling cycle. If needed, a third oil stream can be introduced for the inter module power bus 24.
- A flow-separation plate or baffle 17 is used to separate the first and the second cooling cycle.

Preferably this is arranged in a vertical or substantially vertical direction. Within the spaces of the modules, this plate has feed-throughs e.g. for the intra-module power bus 24. These feed throughs do not need to be 100% oil tight. A small amount of leakage (cross-flow) between the two cooling cycles can be tolerated. The flow-separation plate or baffle 17 is made of an electrically non-conducting material or an insulating material.

In order to improve the circulation and thus the efficiency of the cooling system 6 it is possible to use a pump (not shown) to drive the circulation. The use of a pump or pumps to drive the cooling system 6 falls within the scope of the invention.

In a preferred embodiment of the invention two or more semiconductor modules 4 are stacked vertically above one another, as shown schematically in Figure 1. In another embodiment the semiconductor modules are arranged side by side in stacks 58 as described in relation to Figure 1, but with only one semiconductor module per stack. Thus in the first section 54 of the converter there may be two or more stacks arranged side by side, but each stack only comprises one semiconductor module.

## Claims

1. Electronic subsea system (1), comprising
a housing (2) configured to receive a dielectric fluid (3),
the subsea electronic system comprising a first section (54) and a second section (52) separated by a baffle element (17), wherein at least two electronic modules (1a-4a) having a high heat loss density are arranged in the first section, and at least one electronic modules (1b-4b) having a low heat loss density is arranged in the second section (52),
a cooling system (6) comprising a first heat exchanger (22) in thermal connection with the dielectric fluid, the cooling system providing a first fluid stream path and a second fluid stream path physically separated by the baffle element (17), the first fluid stream path being configured to receive a first fluid stream (16) passing through the first section and the first heat exchanger, the second fluid stream path being configured to receive a second fluid stream (18) passing through the second section (52) and wherein a driving component (19) configured to produce heat losses high enough to create a reliable amount of natural convection is placed in a position in the second fluid stream path.

2. An electronic subsea system (1) according to claim 1, wherein the driving component (19) is configured placed in a position in between an inlet (28) of at least one heat exchanger (23), and at least one apparatus (1b-4b, 8, 29, 9) in the second section (52).

3. An electronic subsea system (1) according to claim 1 or 2, wherein the driving component (19) is configured in a position above at least one apparatus (1b-4b, 8, 29, 9) in the second section (52).

4. An electronic subsea system (1) according to any one of claims 1-3, wherein the at least one driving component (19) comprises at least one electrical or electronic apparatus from the group of: a reactor, a heater, an input filter circuit, an output filter circuit.

5. An electronic subsea system according to any one of claims 1-4, wherein the first heat exchanger (22) is configured to have a higher centre of gravity (d2) than the centre of gravity (d1) of the fluid (3) in the housing (2).

6. An electronic subsea system (1) according to any one of claims 1 to 5, wherein the first section of the at least two electronic modules (1a-4a) comprises a semiconductor element (12).

7. An electronic subsea system (1) according to any one of claims 1 to 6, wherein the second section comprises any of a: capacitor (8), gate drive, control electronics circuit (29), communication bus (9).

8. An electronic subsea system according to claim 1, wherein the baffle element (17) is arranged longitudinally in a substantially vertical direction and separating part of the first fluid stream path in the first section (54) from part of the second fluid stream path in the second section (52).

9. An electronic subsea system (1) according to claim 10, wherein the baffle element (17) comprises an electrically non-conducting material.

10. An electronic subsea system (1) according to claim 1, wherein the first heat exchanger (22) is in thermal connection with the first section (54) and wherein the first fluid stream is configured to cool down the at least one semiconductor element (12).

11. An electronic subsea system (1) according to any one of claims 1-10, wherein the electronic subsea system comprises a converter, a rectifier or an inverter.

12. An electronic subsea system (1) according claim 1, wherein the cooling system comprises a third fluid stream path configured to receive a third fluid stream (20) said third fluid stream being configured to cool down a part of an inter module bus bar (24).

13. An electronic subsea system (1) according to any of the preceding claims, wherein the electronic subsea system is configured for subsea use and wherein the dielectric fluid (3) comprises any of: an oil, a hydrocarbon, an ester, a silicone-based oil.

14. An electronic subsea system (1) according to any of the preceding claims, wherein the third heat exchanger (23) is configured to allow exchange of heat energy between the fluid of the second flow stream (18) and sea water (14) surrounding the housing (2).

15. A method for operating an electronic subsea system (1) according to any one of claims 1-14, **characterised by** supplying a driving component (19) with electric power at a time when a temperature of dielectric fluid in the second section (52) is estimated or measured to be lower than a predetermined value.

## Patentansprüche

1. Elektronisches Unterwassersystem (1), umfassend:
ein Gehäuse (2), das konfiguriert ist, zum Aufnehmen eines dielektrischen Mediums (3),
das elektronische Unterwassersystem, das einen ersten Abschnitt (54) und einen zweiten Abschnitt (52) umfasst, die durch ein Trennelement (17) getrennt sind, wobei mindestens zwei Elektronikmodule (1a bis 4a), die eine hohe Wärmeverlustdichte aufweisen, in dem ersten Abschnitt angeordnet sind, und wobei mindestens ein Elektronikmodul (1b bis 4b), das eine niedrige Wärmeverlustdichte aufweist, in dem zweiten Abschnitt (52) angeordnet ist;
ein Kühlsystem (6), das einen ersten Wärmeübertrager (22) in einer thermischen Verbindung mit dem dielektrischen Medium umfasst, wobei das Kühlsystem einen ersten Medienströmungsweg und einen zweiten Medienströmungsweg bereitstellt, die durch das Trennelement (17) physisch voneinander getrennt sind, wobei der erste Medienströmungsweg konfiguriert ist, um eine erste Medienströmung (16) aufzunehmen, die den ersten Abschnitt und den ersten Wärmeübertrager durchquert, wobei der zweite Medienströmungsweg konfiguriert ist, um eine zweite Medienströmung (18) aufzunehmen, die den zweiten Abschnitt (52) durchquert, und wobei eine Antriebskomponente (19) ausgebildet ist, um Wärmeverluste zu produzieren, die groß genug sind, um eine zuverlässige Menge einer natürlichen Konvektion zu erzeugen, die an einem Ort in dem zweiten Medienströmungsweg platziert wird.

2. Elektronisches Unterwassersystem (1) nach Anspruch 1, wobei die Antriebskomponente (19) ausgebildet ist, um an einem Ort zwischen einem Einlass (28) des mindestens einen Wärmeübertragers (23) und mindestens einer Vorrichtung (1b bis 4b, 8, 29, 9) in dem zweiten Abschnitt (52) platziert zu werden.

3. Elektronisches Unterwassersystem (1) nach Anspruch 1 oder 2, wobei die Antriebskomponente (19) an einem Ort über der mindestens einen Vorrichtung (1b bis 4b, 8, 29, 9) in dem zweiten Abschnitt (52) ausgebildet ist.

4. Elektronisches Unterwassersystem (1) nach einem der Ansprüche 1 bis 3, wobei die mindestens eine Antriebskomponente (19) mindestens eine elektrische oder elektronische Vorrichtung aus der Gruppe umfasst, die besteht aus: einem Reaktor, einem Heizelement, einem Eingangsfilterschaltkreis und einem Ausgangsfilterschaltkreis.

5. Elektronisches Unterwassersystem nach einem der Ansprüche 1 bis 4, wobei der erste Wärmeübertrager (22) ausgebildet ist, um einen Schwerpunkt (d2) aufzuweisen, der höher ist als der Schwerpunkt (d1) des Mediums (3) in dem Gehäuse (2).

6. Elektronisches Unterwassersystem (1) nach einem der Ansprüche 1 bis 5, wobei der erste Abschnitt der mindestens zwei Elektronikmodule (1a bis 4a) ein Halbleiterelement (12) umfasst.

7. Elektronisches Unterwassersystem (1) nach einem der Ansprüche 1 bis 6, wobei der zweite Abschnitt ein beliebiges Element umfasst aus: einem Kondensator (8), einer Gate-Ansteuerung, einem elektronischen Regelkreis (29) und einem Kommunikationsbus (9).

8. Elektronisches Unterwassersystem nach Anspruch 1, wobei das Trennelement (17) in Längsrichtung in einer im Wesentlichen vertikalen Richtung angeordnet ist und einen Teil des ersten Medienströmungswegs in dem ersten Abschnitt (54) von einem Teil des zweiten Medienströmungswegs in dem zweiten Abschnitt (52) trennt.

9. Elektronisches Unterwassersystem (1) nach Anspruch 10, wobei das Trennelement (17) ein elektrisch nichtleitendes Material umfasst.

10. Elektronisches Unterwassersystem (1) nach Anspruch 1, wobei der erste Wärmeübertrager (22) in einer thermischen Verbindung mit dem ersten Abschnitt (54) steht und wobei die erste Medienströmung konfiguriert ist, um das mindestens eine Halbleiterelement (12) abzukühlen.

11. Elektronisches Unterwassersystem (1) nach einem der Ansprüche 1 bis 10, wobei das elektronische Unterwassersystem einen Umrichter, einen Gleichrichter oder einen Wechselrichter umfasst.

12. Elektronisches Unterwassersystem (1) nach Anspruch 1, wobei das Kühlsystem einen dritten Medienströmungsweg umfasst, der ausgebildet ist, um eine dritte Medienströmung (20) aufzunehmen, wobei die dritte Medienströmung konfiguriert ist, um einen Teil einer modulübergreifenden Sammelschiene (24) abzukühlen.

13. Elektronisches Unterwassersystem (1) nach einem der vorhergehenden Ansprüche, wobei das elektronische Unterwassersystem für eine Unterwasserverwendung ausgebildet ist und wobei das dielektrische Medium (3) ein Element umfasst aus: einem Öl, einem Kohlenwasserstoff, einem Ester oder einem siliziumbasierten Öl.

14. Elektronisches Unterwassersystem (1) nach einem der vorhergehenden Ansprüche, wobei der dritte Wärmeübertrager (23) ausgebildet ist, um ein Übertragen einer Wärmeenergie zwischen dem Medium der zweiten Medienströmung (18) und dem Meereswasser (14) zu erlauben, welches das Gehäuse (2) umgibt.

15. Verfahren zum Betreiben eines elektronische Unterwassersystems (1) nach einem der Ansprüche 1 bis 14, **gekennzeichnet durch** ein Versorgen einer Antriebskomponente (19) mit einer elektrischen Energie zu einem Zeitpunkt, wenn geschätzt oder gemessen wird, dass eine Temperatur des dielektrischen Mediums in dem zweiten Abschnitt (52) niedriger als ein vorbestimmter Wert ist.

## Revendications

1. Système sous-marin électronique (1), comprenant
un boîtier (2) configuré pour recevoir un liquide diélectrique (3),
le système électronique sous-marin comprenant une première section (54) et une deuxième section (52) séparées par un élément servant de cloison (17), au moins deux modules électroniques (la à 4a) ayant une densité de perte calorifique élevée étant agencés dans la première section, et au moins un module électronique (1b à 4b) ayant une faible densité de perte calorifique étant agencé dans la deuxième section (52),
un système de refroidissement (6) comprenant un premier échangeur de chaleur (22) en connexion thermique avec le liquide diélectrique, le système de refroidissement établissant un premier trajet de courant de liquide et un deuxième trajet de courant de liquide séparés physiquement par l'élément servant de cloison (17), le premier trajet de courant de liquide étant configuré pour recevoir un premier courant de liquide (16) traversant la première section et le premier échangeur de chaleur, le deuxième trajet de courant de liquide étant configuré pour recevoir un deuxième courant de liquide (18) traversant la deuxième section (52), un composant de commande (19) configuré pour produire des pertes calorifiques suffisamment élevées pour créer une quantité fiable de convection naturelle étant disposé à une certaine position dans le deuxième trajet de courant de liquide.

2. Système sous-marin électronique (1) selon la revendication 1, dans lequel le composant de commande (19) est configuré de façon à être placé à une certaine position entre une entrée (28) d'au moins un échangeur de chaleur (23), et au moins un appareil (1b à 4b, 8, 29, 9) de la deuxième section (52).

3. Système sous-marin électronique (1) selon la revendication 1 ou 2, dans lequel le composant de commande (19) est configuré à une certaine position au-dessus d'au moins un appareil (1b à 4b, 8, 29, 9) de la deuxième section (52).

4. Système sous-marin électronique (1) selon l'une quelconque des revendications 1 à 3, dans lequel ledit au moins un composant de commande (19) comprend au moins un appareil électrique ou électronique provenant du groupe comprenant : un réacteur, un élément chauffant, un circuit de filtrage d'entrée, un circuit de filtrage de sortie.

5. Système sous-marin électronique selon l'une quelconque des revendications 1 à 4, dans lequel le premier échangeur de chaleur (22) est configuré pour avoir un centre de gravité (d2) plus élevé que le centre de gravité (d1) du liquide (3) dans le boîtier (2).

6. Système sous-marin électronique (1) selon l'une quelconque des revendications 1 à 5, dans lequel la première section desdits au moins deux modules électroniques (la à 4a) comprend un élément semi-conducteur (12).

7. Système sous-marin électronique (1) selon l'une quelconque des revendications 1 à 6, dans lequel la deuxième section comprend n'importe quel élément parmi : un condensateur (8), une commande de grille, un circuit électronique de commande (29) un bus de communication (9) .

8. Système sous-marin électronique (1) selon la revendication 1, dans lequel l'élément servant de cloison (17) est disposé longitudinalement dans une direction sensiblement verticale et sépare une partie du premier trajet de courant de liquide de la première section (54) d'une partie du deuxième trajet de courant de liquide de la deuxième section (52).

9. Système sous-marin électronique (1) selon la revendication 10, dans lequel l'élément servant de cloison (17) comprend un matériau qui n'est pas électriquement conducteur.

10. Système sous-marin électronique (1) selon la revendication 1, dans lequel le premier échangeur de chaleur (22) est en connexion thermique avec la première section (54) et dans lequel le premier courant de liquide est configuré pour refroidir ledit au moins un élément semi-conducteur (12).

11. Système sous-marin électronique (1) selon l'une quelconque des revendications 1 à 10, le système sous-marin électronique comprenant un convertisseur, un redresseur ou un inverseur.

12. Système sous-marin électronique (1) selon la revendication 1, dans lequel le système de refroidissement comprend un troisième trajet de courant de liquide configuré pour recevoir un troisième courant de liquide (20), le troisième courant de liquide étant configuré pour refroidir une partie d'une barre omnibus inter-modules (24).

13. Système sous-marin électronique (1) selon l'une quelconque des revendications précédentes, le système sous-marin électronique étant configuré pour l'utilisation sous-marine, et le liquide diélectrique (3) comprenant n'importe quel élément parmi : une huile, un hydrocarbure, un ester, une huile à base de silicone.

14. Système sous-marin électronique (1) selon l'une quelconque des revendications précédentes, dans lequel le troisième échangeur de chaleur (23) est configuré pour autoriser l'échange d'énergie thermique entre le liquide du deuxième courant de liquide (18) et l'eau de mer (14) entourant le boîtier (2).

15. Procédé d'exploitation d'un système sous-marin électronique (1) selon l'une quelconque des revendications 1 à 14, **caractérisé par** la fourniture d'une alimentation électrique à un composant de commande (19) au moment où une température estimée ou mesurée du liquide diélectrique présent dans la deuxième section (52) est inférieure à une valeur prédéterminée.
